(19) Europäisches Patentamt
European Patent Office
Office européen des brevets

(11) **EP 2 610 646 B1**

(12) **EUROPEAN PATENT SPECIFICATION**

(45) Date of publication and mention
of the grant of the patent:
**21.01.2015 Bulletin 2015/04**

(51) Int Cl.:
***G01V 1/52*** *(2006.01)*

(21) Application number: **11290614.4**

(22) Date of filing: **26.12.2011**

(54) **Methods and packages to protect electronics components in a subterranean environment**

Verfahren und Pakete zum Schutz elektronischer Komponenten in einer unterirdischen Umgebung

Procédés et paquets pour protéger les composants électroniques dans un milieu souterrain

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**03.07.2013 Bulletin 2013/27**

(73) Proprietors:
• **Services Pétroliers Schlumberger**
**75007 Paris (FR)**
Designated Contracting States:
**FR**
• **Schlumberger Technology B.V.**
**2514 JG The Hague (NL)**
Designated Contracting States:
**AL BG CZ DE DK GR HU IE IT LT MK NO PL RO RS SI SK SM TR**
• **Schlumberger Holdings Limited**
**Tortola BV1 (VG)**
Designated Contracting States:
**GB NL**
• **PRAD Research and Development Limited**
**Road Town, Tortola (VG)**
Designated Contracting States:
**AT BE CH CY EE ES FI HR IS LI LU LV MC MT PT SE**

(72) Inventors:
• **Parry, Andrew**
**92340 Bourg La Reine (FR)**
• **Garando, Lahcen**
**91400 Orsay (FR)**
• **Barbara, François**
**78500 Sartrouville (FR)**
• **Sellin, Jacques**
**91700 Sainte Geneviève Des Bois (FR)**
• **Denoix, Henri**
**92142 Clamart Cedex (FR)**
• **Jacob, Gregoire**
**92142 Clamart Cedex (FR)**
• **Liu, Junchen**
**92142 Clamart Cedex (FR)**

(74) Representative: **Rzaniak, Martin**
**European Patent Attorney**
**Etudes & Productions Schlumberger**
**1, rue Henri Becquerel**
**92142 Clamart Cedex (FR)**

(56) References cited:
**US-A- 2 156 052     US-A- 5 239 514**
**US-A1- 2003 025 613     US-A1- 2005 000 279**
**US-A1- 2008 150 750**

## Description

## Background

In geologic investigation and study, for example in connection with the exploration of geological formations, such as for petrochemical fossil deposits within the earth, harsh conditions can be present in the formation environment. Conditions that may be present can include for example high pressures, high temperatures, high levels of shock and vibration, and various cycling among such conditions, where some or all of which may be present for example during operations such as investigation and study of formations and/or during drilling into or otherwise entering formations. Downhole tools of varying purposes have been used for operations such as those above, for example in exploring subterranean formations. Further, in some applications of downhole tools, such as for example formation evaluation, various electronics can be employed within the downhole tool.

## Summary

Electronics components can be hermetically packaged for example by using cofired metal and/or cofired ceramic as a packaging material. Cofired metal and/or ceramic technology can produce parts of various shapes, and can also have conductive layer(s) and/or track(s), for example made of metal, that are embedded in the packaging materials. The conductive layer(s) and/or track(s) can be used as electrical conductors to electrically connect the electronics component(s) inside the package to those outside the package. In appropriate circumstances, such packages can allow to place the electronics component(s) inside the package, which can be sealed for example by bonding and/or brazing the packaging material together, and to connect the electronics component(s) for example to the conductive layer(s) and/or track(s) that may be embedded within the package. In some instances, such embedded conductive layer(s) and/or track(s) can exit the package for example as metallic plated pads such as by using wire bonding, brazing, and/or bonding. The package can then be hermetically sealed with brazed and/or bonded joints. The electrical conductors that exit the package can be connected to other electronics components, such as by brazing, bonding, and/or spring contact. The package can form a hermetic package with compressive resistance to allow electronics component(s) to be disposed in, for example, a subterranean environment.

Electronics components that are employed for example within a downhole tool can remain electrically functional if packaged appropriately, and while the downhole tool may be exposed to the formation environment, such as a subterranean environment, which can include for example exposure to the geological material present in the formation and sometimes exposure to drilling fluid that may be present in the formation. Embodiments herein are directed to methods and packages to contain electronics component(s) and that can be disposed in a subterranean environment, such as within a downhole tool. In particular, embodiments herein relate to packaging electronics components hermetically so that they may be disposed in harsh environments such as may be present in a subterranean formation, including conditions such as for example high pressures, high temperatures, high levels of shock and vibration, and various cycling among such conditions.

Generally, embodiments of packages and methods described herein include use of characteristic dimension(s) to improve the strength thereof. For example, embodiments of packages and methods described herein can reduce stress in the packaging material, for example reducing stresses at sealing interfaces of the packaging material, and that can reduce movement between parts of the packaging material experiencing pressure and/or temperature loads.

In some embodiments, characteristic dimension(s) for the package can include a certain wall thickness or thicknesses and/or can include a certain flatness to its seal surfaces.

In one embodiment, a package includes a first body with an outer surface and an inner surface, a second body with an outer surface and an inner surface, and a cavity that is formed by the inner surfaces of the first and second bodies. The package includes at least one electronics component contained within the cavity. The package includes at least one seal surface on the first body and at least one seal surface on the second body that are arranged to seal the first body with the second body.

For example in some embodiments, at least one of the seal surfaces includes a wall thickness dimension, t, that extends toward the cavity from the outer surface of at least one of the first body and the second body. The wall thickness dimension, t, can be determined by $t \geq a * L$, where, a, is a coefficient. Either alone or in combination with the selected wall thickness dimension, t, described above, other embodiments can include at least one of the seal surfaces to have a flatness relative to a simulated plane of the seal surface(s). The flatness is based on one or more angle deviations along the seal surface(s) relative to the simulated plane, where each angle deviation being an angle taken between a portion of the seal surface(s) and the simulated plane, and being less than a threshold value.

In some embodiments, the wall thickness dimension, t, and/or the flatness can be selected such that the electronics component(s) are electrically functional within the package subjected to an environment that has thermal and pressure cycling, the thermal cycling ranging from about -40°C to about 300°C and the pressure cycling ranging from about 0bar to about 3000bars.

In some embodiments, the wall thickness dimension, t, and/or the flatness can be selected so that the package has a maximum principal stress level of up to about 20 MPa.

In some embodiments, the electronics component(s) includes at least one of a crystal oscillator, a ceramic oscillator, an integrated circuit, and a sensor.

In some embodiments, the package can be disposed or otherwise included inside a component of a downhole tool, and can be deployed for example in a subterranean environment.

This summary is provided to introduce a selection of concepts that are further described below in the detailed description. This summary is not intended to identify key or essential features of the claimed subject matter, nor is it intended to be used as an aid in limiting the scope of the claimed subject matter.

**Drawings**

Fig. 1A illustrates a schematic side view in section of one embodiment of a package that can have electronics disposed therein.

Fig. 1B illustrates a schematic side view in section of one embodiment of a package that can have electronics disposed therein.

Fig. 1C illustrates a schematic side view in section of one embodiment of a package that can have electronics disposed therein.

Fig. 1D illustrates a schematic side view in section of one embodiment of a package that can have electronics disposed therein.

Fig. 1E illustrates a schematic side view in section of one embodiment of a package that can have electronics disposed therein.

Fig. 1F illustrates a schematic side view in section of one embodiment of a package that can have electronics disposed therein.

Fig. 1G illustrates a schematic side view in section of one embodiment of a package that can have electronics disposed therein.

Fig. 1H illustrates a schematic side view in section of one embodiment of a package that can have electronics disposed therein.

Fig. 2A illustrates a schematic view of an embodiment of a shape of a package that may be employed as the package shape in any of the packages of Figs. 1A-1H.

Fig. 2B illustrates a schematic view of an embodiment of a shape of a package that may be employed as the package shape in any of the packages of Figs. 1A-1H.

Fig. 3A illustrates a schematic side view in section of another embodiment of a package that can have electronics disposed therein.

Fig. 3B illustrates a schematic side view in section of another embodiment of a package that can have electronics disposed therein.

Fig. 3C is a top view of the package of Fig. 3B.

Fig. 3D illustrates a schematic side view in section of one embodiment of a package that can have electronics disposed therein.

Fig. 4 illustrates another embodiment of a package in a simulated partial view that can have electronics disposed therein, and showing a quarter portion of the package.

Fig. 5 illustrates a portion of a seal surface of a part of the package of Fig. 4 that may be evaluated for flatness.

Fig. 6 illustrates a schematic example of flatness of the portion of the seal surface of Fig. 5 relative to a simulated plane of the seal surface.

Fig. 7 illustrates part of the package of Fig. 4 and shown in Fig. 5, and which shows the pressure applied on a reduced portion of the package.

Fig. 8 illustrates tension, or maximum principal stress on the seal surface of part of the package of Fig. 4 and shown in Fig. 5 when a non-uniform mating pressure is applied.

Fig. 9 illustrates an example of pressure cycling and temperature cycling on the package of Fig. 4.

Figs. 10A-10E illustrate results of the pressure cycling and temperature cycling of Fig. 9.

Fig. 11A illustrates a schematic example of a downhole tool in which can be contained a package that has electronics disposed in the downhole tool.

Fig. 11B illustrates a component of the downhole tool of Fig. 11A that can contain the package.

Fig. 12 illustrates one example of a method of disposing electronics in a subterranean environment.

**Detailed Description**

Specific details are given in the following description to provide a thorough understanding of the embodiments. However, it will be understood by one of ordinary skill in the art that the embodiments may be practiced without these specific details. For example, certain components, methods, and other aspects may be shown in schematic form and/or block diagram in order not to obscure the embodiments in unnecessary detail.

Electronics components that are employed for example within a downhole tool can remain electrically functional if packaged appropriately, and while the downhole tool may be exposed to a formation environment, such as a subterranean environment. In particular, embodiments herein relate to packaging electronics components hermetically so that they may be disposed in harsh environments such as may be present in a subterranean formation, including conditions such as for example high pressures, high temperatures, high levels of shock and vibration, and various cycling among such conditions.

Generally, embodiments of packages and methods described herein include use of characteristic dimension(s) to improve the strength thereof. In some embodiments, characteristic dimension(s) for the package can include a certain wall thickness or thicknesses and/or can include a certain flatness to its seal surfaces. Such characteristic dimension(s) will be described further below.

Examples of package structures and shapes

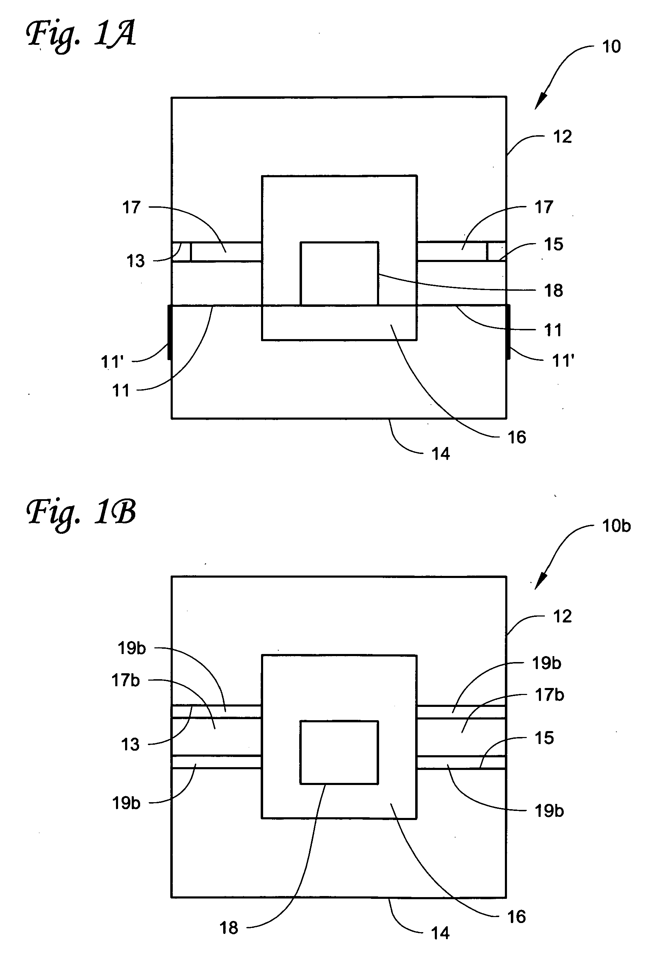

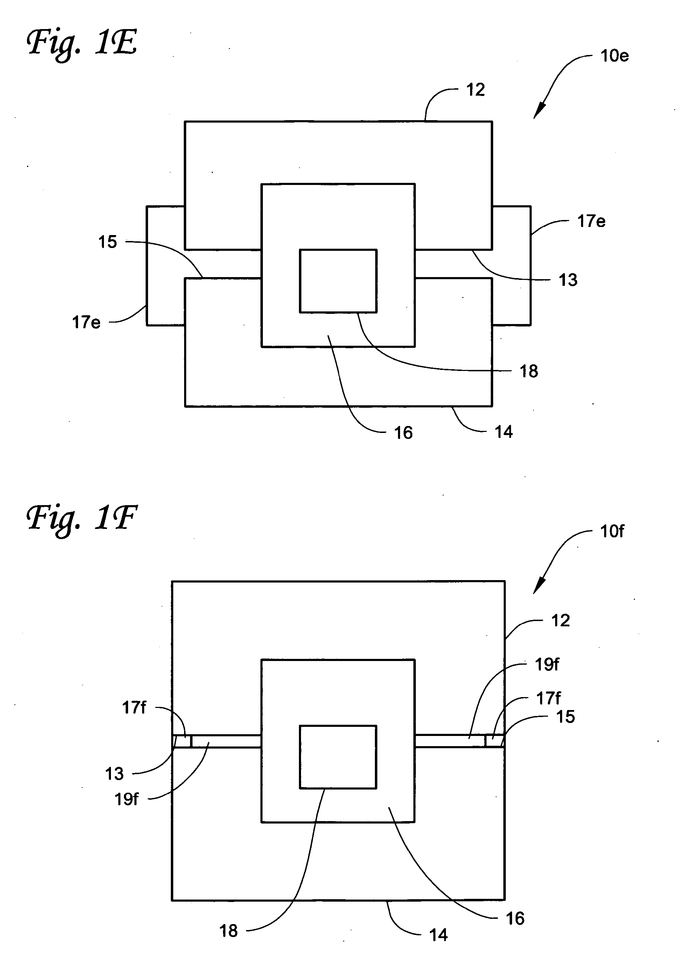

Referring to Figs. 1A through 1H, various schematic views in section illustrate embodiments of packages 10 to 10g and 20 that can have electronics disposed therein. Generally, each of the packages illustrated includes a first body with an outer surface and an inner surface, and includes a second body with an outer surface and an inner surface. The packages include a cavity that is formed by the inner surfaces of the first and second bodies. The packages each include one or more electronics component contained within the cavity. In some embodiments, the electronics component can be at least one of a crystal oscillator, a ceramic oscillator, an integrated circuit, and a sensor. For example, a crystal oscillator is an electronic circuit that can use the mechanical resonance, for example of a vibrating crystal of piezoelectric material to create an electrical signal. Electronics components such as above can be used for example in downhole tools that may be deployed in a subterranean formation, for example. Environmental changes of temperature, humidity, pressure, and/or vibration, or other conditions that may be present in a subterranean formation can affect the operation and functionality of electronics components that may be disposed in a downhole tool. One example of this is with respect to a crystal oscillator, which may experience for example changes in the resonance frequency of a quartz crystal in relatively harsh conditions. Packages described herein can contain such electronics components and allow them to remain electrically functional under such conditions.

Each package also includes one or more seal surfaces on the first body and one or more seal surfaces on the second body that are arranged to seal the first body with the second body. In some embodiments, each package can include a seal material that is disposed between the one or more seal surfaces of the first and second bodies. The seal material can be for example formed by brazing of metals, such as for example by high melting point brazing or such as with a gold-tin (AuSn) material. It will be appreciated that other seal materials may be employed, such as ceramic glue(s).

Referring to Fig. 1A, a package 10 includes a first body 12 with an outer surface and an inner surface, and includes a second body 14 with an outer surface and an inner surface. The package 10 includes a cavity 16 that is formed by the inner surfaces of the first and second bodies 12, 14. The package 10 includes at least one electronics component 18 contained within the cavity 16. The package 10 includes at least one seal surface 13 on the first body 12 and at least one seal surface 15 on the second body 14 that are arranged to seal the first body 12 with the second body 14. In some embodiments, a seal material 17 is disposed between the one or more seal surfaces 13, 15 of the first and second bodies 12, 14. As shown, the seal material 17 extends along portions of the seal surfaces 13, 15 between the first and second bodies 12, 14, but may not extend to the exterior of the package 10.

Also, the package 10 includes one or more electrical conductors 11 that can electrically connect the electronics component 18 with electronics outside package. In the embodiment shown, there are two electrical conductors 11, however it will be appreciated that more than two conductors or one conductor may be employed as may be appropriate. In one embodiment, the electrical conductors 11 can be a layer, track or line of conductive material, such as a metal. In the embodiment shown, the electrical conductors 11 can be partially embedded in the package, such as by cofiring the package material of the first and second bodies 12, 14, which can be for example ceramic and/or metal. As shown, the electrical conductors 11 can extend from the electronics component 18 through any one or more of the first and second bodies 12, 14 to the outer surface or exterior of the package 10. In the embodiment shown, the electrical conductors 11 form a contact 11' on the outer surface of the package 10, which can be in the form of a pad. It will be appreciated that any of the packages shown or described herein, including those of Figs. 1B to 1H, 3A, 3D, and 4, may employ electrical conductors and contacts such as shown in Fig. 1A. It will be appreciated that, although not specifically shown in these Figures, one of skill in the art would be able to put in electrical conductors and contacts, for example such as similarly shown in Fig. 1A and as described above.

Referring to Fig. 1B, a package 10b includes, similarly as package 10, a first body 12 with an outer surface and an inner surface, and includes a second body 14 with an outer surface and an inner surface. The package 10b includes a cavity 16 that is formed by the inner surfaces of the first and second bodies 12, 14. The package 10b includes at least one electronics component 18 contained within the cavity 16. The package 10b includes at least one seal surface 13 on the first body 12 and at least one seal surface 15 on the second body 14 that are arranged to seal the first body 12 with the second body 14. Differently, seal material 17b is disposed between the seal surfaces 13, 15 of the first and second bodies 12, 14, and extends to the outer surface of the first and second bodies 12, 14. As shown, one or more metal layers 19b can be disposed between the seal material 17b and the seal surfaces 13, 15 of the first and second bodies 12, 14 and also extend toward the outer surface of the first and second bodies 12, 14.

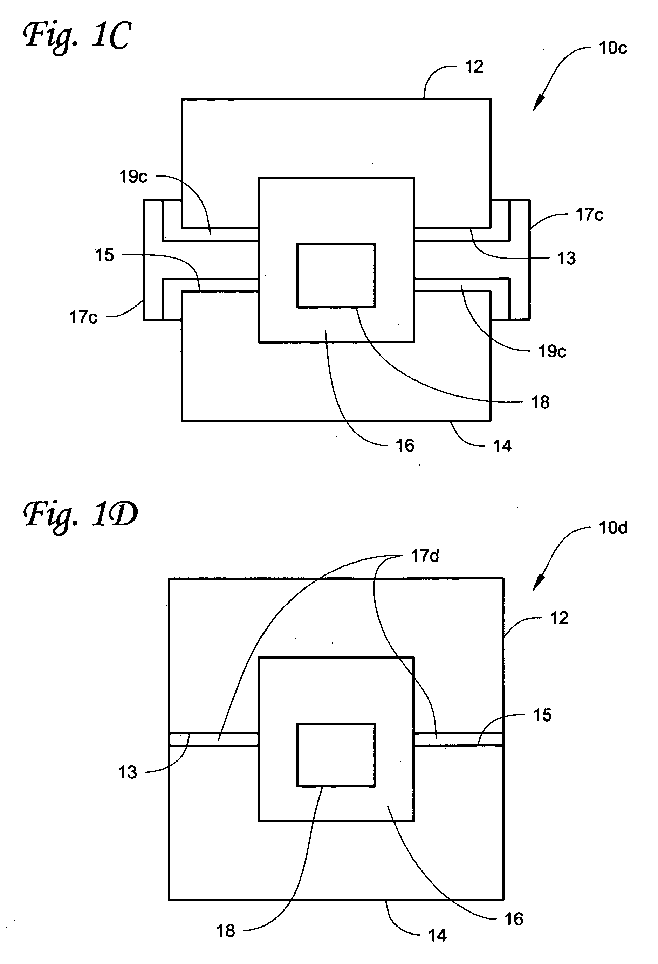

Referring to Fig. 1C, a package 10c includes, similarly as package 10, a first body 12 with an outer surface and an inner surface, and includes a second body 14 with an outer surface and an inner surface. The package 10c includes a cavity 16 that is formed by the inner surfaces of the first and second bodies 12, 14. The package 10c includes at least one electronics component 18 contained within the cavity 16. The package 10c includes at least one seal surface 13 on the first body 12 and at least one seal surface 15 on the second body 14 that are arranged to seal the first body 12 with the second body 14. Seal material 17c is disposed between the seal surfaces 13, 15 of the first and second bodies 12, 14. Differently, seal material 17c extends between the seal surfaces 13, 15 and over a portion of the outer surface of the first and second bodies 12, 14. It will be appreciated that the seal material 17c may extend over one of the first or second bodies 12, 14. As shown, one or more metal layers 19c can be disposed between the seal material 17c and the seal surfaces 13, 15 of the first and second bodies 12, 14. As shown, the metal layers 19c extend to an exterior of the package 10c and over a portion of the outer surface of one or more of the first and second bodies 12, 14. It will be appreciated that the metal layers 19c may extend over one of the first and second bodies 12, 14.

Referring to Fig. 1D, a package 10d includes, similarly as package 10, a first body 12 with an outer surface and an inner surface, and includes a second body 14 with an outer surface and an inner surface. The package 10d includes a cavity 16 that is formed by the inner surfaces of the first and second bodies 12, 14. The package 10d includes at least one electronics component 18 contained within the cavity 16. The package 10d includes at least one seal surface 13 on the first body 12 and at least one seal surface 15 on the second body 14 that are arranged to seal the first body 12 with the second body 14. Seal material 17d is disposed between the seal surfaces 13, 15 of the first and second bodies 12, 14, and extends along the seal surfaces 13, 15 to the exterior of the package 10d. In some embodiments, the seal material 17d may be a ceramic glue, rather than metal layers or formed from brazing.

Referring to Fig. 1E, a package 10e includes, similarly as package 10, a first body 12 with an outer surface and an inner surface, and includes a second body 14 with an outer surface and an inner surface. The package 10e includes a cavity 16 that is formed by the inner surfaces of the first and second bodies 12, 14. The package 10e includes at least one electronics component 18 contained within the cavity 16. The package 10e includes at least one seal surface 13 on the first body 12 and at least one seal surface 15 on the second body 14 that are arranged to seal the first body 12 with the second body 14. Seal material 17e is disposed between the seal surfaces 13, 15 of the first and second bodies 12, 14. Seal material 17e extends along the seal surfaces 13, 15 and over a portion of the outer surface of the first and second bodies 12, 14. It will be appreciated that the seal material 17e may extend over one of the first or second bodies 12, 14. In some embodiments, the seal material 17e may be a ceramic glue, rather than metal layers or formed from brazing.

Referring to Fig. IF, a package 10f includes, similarly as package 10, a first body 12 with an outer surface and an inner surface, and includes a second body 14 with an outer surface and an inner surface. The package 10f includes a cavity 16 that is formed by the inner surfaces of the first and second bodies 12, 14. The package 10f includes at least one electronics component 18 contained within the cavity 16. The package 10f includes at least one seal surface 13 on the first body 12 and at least one seal surface 15 on the second body 14 that are arranged to seal the first body 12 with the second body 14. Seal material 17f is disposed between the seal surfaces 13, 15 of the first and second bodies 12, 14. In the embodiment shown, seal material 17f extends along a portion of the seal surfaces 13, 15 toward the exterior of the package 10f. Further, in some embodiments, a metal layer 19f can be disposed between the seal surfaces 13, 15 and can extend along the seal surfaces 13, 15 toward the cavity 16. It will be appreciated that the seal material 17f can be a ceramic glue, rather than a metal layer or formed from brazing.

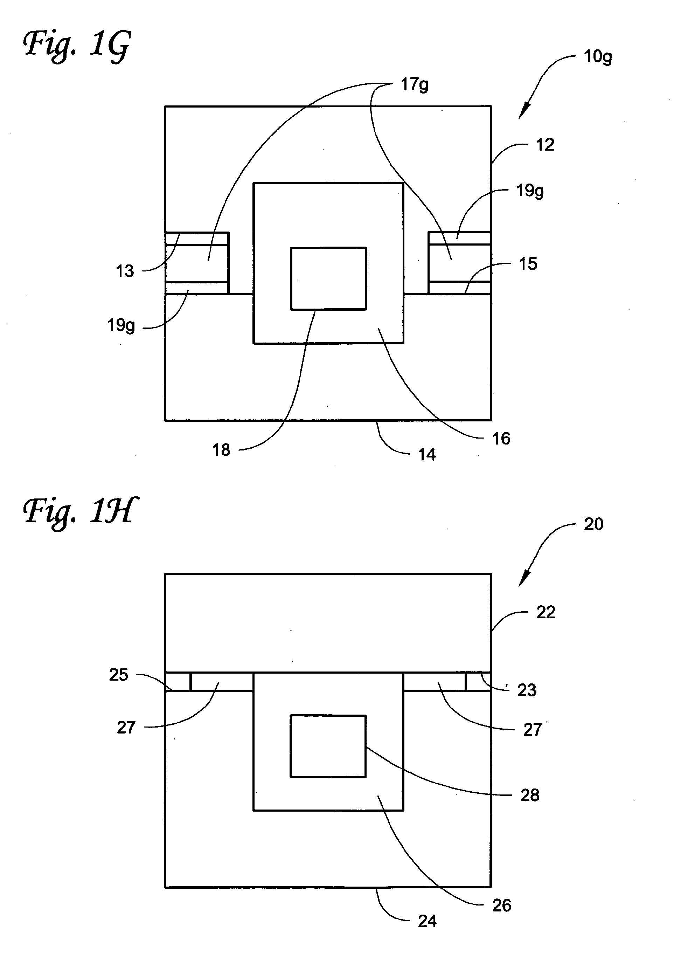

Referring to Fig. 1G, a package 10g includes, similarly as package 10, a first body 12 with an outer surface and an inner surface, and includes a second body 14 with an outer surface and an inner surface. The package 10g includes a cavity 16 that is formed by the inner surfaces of the first and second bodies 12, 14. The package 10g includes at least one electronics component 18 contained within the cavity 16. The package 10g includes at least one seal surface 13 on the first body 12 and at least one seal surface 15 on the second body 14 that are arranged to seal the first body 12 with the second body 14. In the embodiment shown, the seal surface 13 of the first body 12 includes a stepped or shoulder portion. It will be appreciated that the seal surface 15 of the second body 14 could have the stepped or shoulder portion. Seal material 17g is disposed between the seal surfaces 13, 15 of the first and second bodies 12, 14 and to the shoulder of the first body 12. Seal material 17g is disposed between the seal surfaces 13, 15, and extends toward the exterior of the package 10g. In the embodiment shown, a metal layer 19g can be disposed between the seal surfaces 13, 15 and seal material 17g and extend toward the exterior of the package. In some embodiments, a ceramic glue may also be employed between the seal surfaces of the first and second bodies 12, 14 at the portion beyond the shoulder portion and toward the cavity 16.

Referring to Fig. 1H, a package 20 includes a first body 22 with an outer surface and an inner surface, and includes a second body 24 with an outer surface and an inner surface. The package 20 includes a cavity 26 that is formed by the inner surfaces of the first and second bodies 22, 24. The package 20 includes at least one electronics component 28 contained within the cavity 26. The package 20 includes at least one seal surface 23 on the first body 22 and at least one seal surface 25 on the second body 24 that are arranged to seal the first body 22 with the second body 22. Seal material 27 is disposed between the seal surfaces 23, 25 of the first and second bodies 22, 24. As shown, seal material 27 extends along portions of the seal surfaces 23, 25 between the first and second bodies 22, 24 but may not extend to the exterior of the package 20. Differently from Figs. 1A to 1G, the package 20 resembles a lid structure for first body 22 that covers second body 24. It will be appreciate that the second body 24 may be the lid-like structure, rather than the first body 22, and can cover the first body 22.

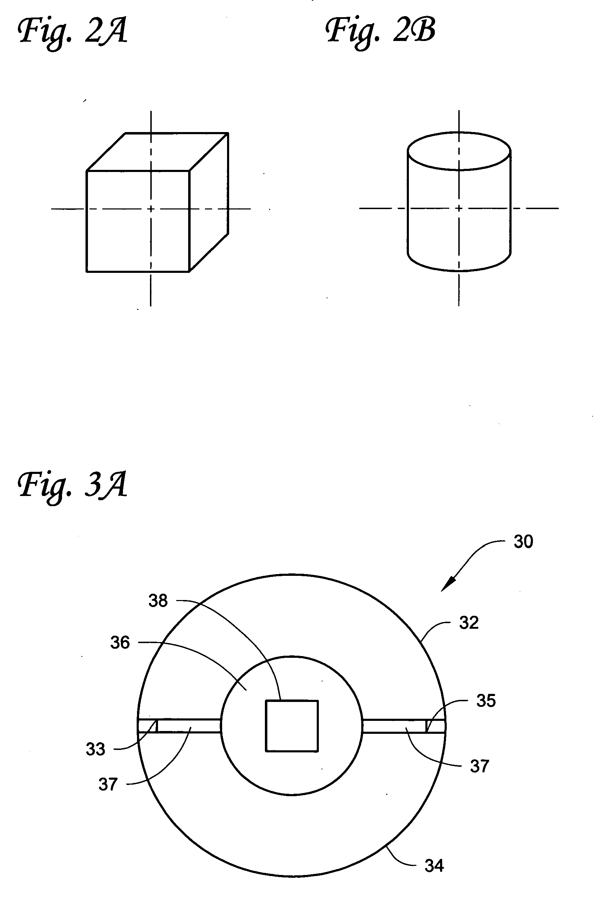

Figs. 2A and 2B show schematic views of different embodiments for the outer shape of a package, either of which may be employed as the package shape in any of the packages of Figs. 1A-1H. As shown, Fig. 2A shows a rectangular or "box-like" structure, and Fig. 2B shows a cylindrical structure. The vertical and horizontal lines therethrough can represent axes through which section views such as the schematic views of Figs. 1A-1H may be taken. For the cylindrical shape of Fig. 2B, the schematic views of Figs. 1A-1H may be taken from the vertical axis rather than the horizontal axis.

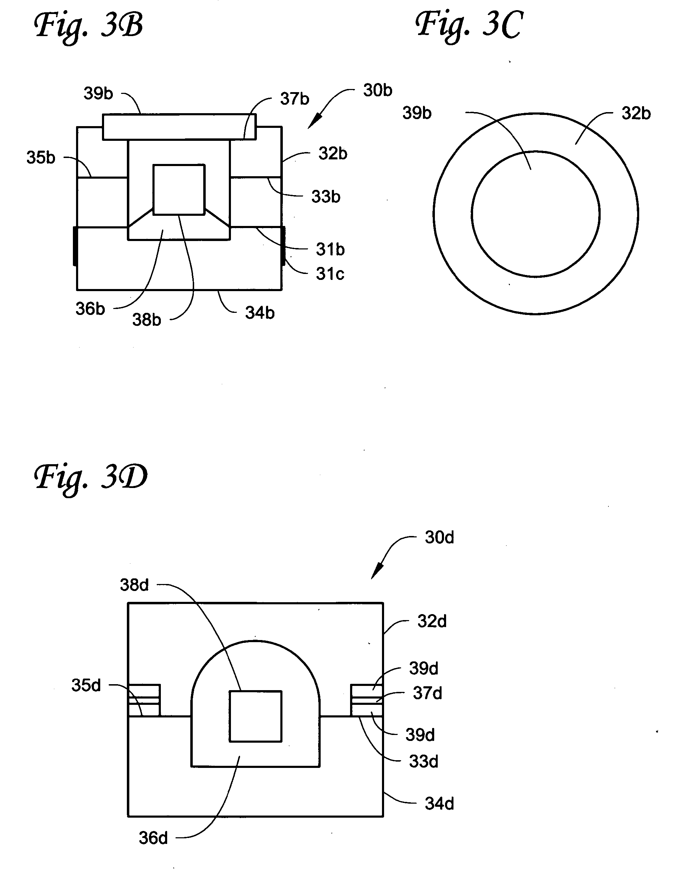

Fig. 3A illustrates a schematic sectional view of another embodiment of a package 30 that can have electronics disposed therein. The section from which the schematic of package 30 can be taken, for example can be the horizontal axis of the cylindrical package shape of Fig. 2B. Package 30 includes a first body 32 with an outer surface and an inner surface, and includes a second body 34 with an outer surface and an inner surface. The package 30 includes a cavity 36 that is formed by the inner surfaces of the first and second bodies 32, 34. The package 30 includes at least one electronics component 38 contained within the cavity 36. The package 30 includes at least one seal surface 33 on the first body 32 and at least one seal surface 35 on the second body 34 that are arranged to seal the first body 32 with the second body 32. Seal material 37 is disposed between the seal surfaces 33, 35 of the first and second bodies 32, 34. As shown, seal material 37 extends along portions of the seal surfaces 33, 35 between the first and second bodies 32, 34 but in some cases may not extend to the exterior of the package 30.

Figs. 3B and 3C illustrate a schematic sectional view of another embodiment of a package 30b that can have electronics disposed therein. The section from which the schematic view of package 30b can be taken, for example can be the vertical axis of the cylindrical package shape of Fig. 2B. Package 30b includes a first body 32b with an outer surface and an inner surface, and includes a second body 34b with an outer surface and an inner surface. The package 30b includes a cavity 36b that is formed by the inner surfaces of the first and second bodies 32b, 34b. The package 30b includes at least one electronics component 38b contained within the cavity 36b. The package 30b includes at least one seal surface 33b on the first body 32b and at least one seal surface 35b on the second body 34b that are arranged to seal the first body 32b with the second body 32b. The first and second bodies 32b, 34b can be sealed at the seal surfaces 33b, 35b, through a ceramic glue or any of the seal materials described above. In some embodiments, an additional cover structure may be employed for example, cover 39b may be disposed in a shoulder portion 37b of first body 32b. In some embodiments, the cover 39b can be a metal alloy, such as for example titanium, which may be brazed to the first body 32b. In some embodiments, the first body 32b may be sealed to the second body 34b by cofiring or brazing. Similar to Fig. 1A, the package 30b can include electrical conductors 31b and pads or outer contacts 31c. Fig. 3C is a top view of the package showing the first body 32b and the cover 39b.

Fig. 3D a package 30d includes a first body 32d with an outer surface and an inner surface, and includes a second body 34d with an outer surface and an inner surface. The package 30d includes a cavity 36d that is formed by the inner surfaces of the first and second bodies 32d, 34d. The package 30d includes at least one electronics component 38d contained within the cavity 36d. The package 30d includes at least one seal surface 33d on the first body 32d and at least one seal surface 35d on the second body 34d that are arranged to seal the first body 32d with the second body 34d. In the embodiment shown, first body 32d includes a stepped or shoulder portion. It will be appreciated that the second body 34d could have the stepped or shoulder portion. Seal material 37d is disposed between the seal surfaces 33d, 35d of the first and second bodies 32d, 34d and to the shoulder portion of the first body 32d. The seal material 37d is disposed between the seal surfaces 33d, 35d, and extends toward the exterior of the package 30d. In the embodiment shown, a metal layer 39d can be disposed between the seal surfaces 33d, 35d and seal material 37d and extend toward the exterior of the package 30d. In some embodiments, a ceramic glue may be employed between the seal surfaces first and second bodies 32d, 34d at the portion beyond the shoulder portion and toward the cavity 36d. In the embodiment shown, the cavity may in part include a half cylinder or hemispherical shape.

Characteristic dimensions that can improve package strength

As above, embodiments of packages described herein include use of characteristic dimension(s) to improve the strength thereof. In some embodiments, characteristic dimension(s) for the package can include a certain wall thickness or thicknesses and/or can include a certain flatness to its seal surfaces.

For example in some embodiments, the one or more seal surfaces of the first body and the second body includes a characteristic dimension of wall thickness dimension, t, that extends toward the cavity from the outer surface of at least one of the first body and the second body. The wall thickness dimension, t, can be determined by the expression:

$$t \geq a * L,$$

where L is a characteristic dimension that is a square root of a surface area taken from a face of the cavity, and where, a, is a coefficient.

It will be appreciated that the characteristic dimension, L, and the coefficient, a, can be obtained through modelling and simulation, such as through stress and deflection testing. It will be appreciated that the above expression may be employed to determine or otherwise select a wall thickness dimension, t, of the one or more seal surfaces of any of the packages described above in Figs. 1A-1H, 2A, 2B, and 3A-3D.

With reference to the characteristic dimension, L, the "face" from which the square root of a surface area may be obtained can be, for example, a surface that defines a boundary of the cavity or an imaginary dimension within the volume of the cavity. For example, a surface that defines a boundary of the cavity can be an inner surface of the first or second body of any of the packages described above. In other embodiments, the "face" from which the square root of the surface area may be obtained can be an imaginary plane taken from a cross section, such as for example across the cavity. In some embodiments, the "face" can be selected that is the largest surface or imaginary plane across the volume of the cavity, depending on the shape of the cavity.

With reference to the coefficient, a, in some embodiments this can be obtained based on a scaled simulation of the package for which the wall thickness is to be determined. In some embodiments, the reference simulation is of a package and cavity shape that is of similar package and cavity shape relative to the package for which a wall thickness, t, is to be selected.

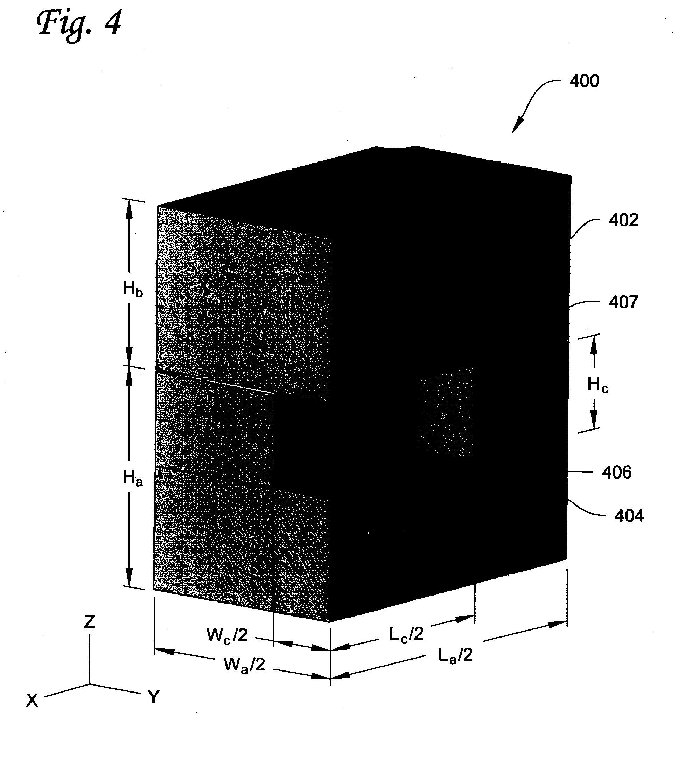

An example of obtaining the coefficient "a" is explained below with regard to Object 1 (reference simulation) and Object 2 (desired package), and also with reference to package 400 in Fig. 4. For example, coefficient "a" can be a function related to the volume of the cavity of the package and characteristic dimension L of the cavity.

Objects 1 and 2 can be geometrically scaled versions of each other, so the volume of Object 2 can be equal to a factor times the volume of Object 1 ($V_2$=factor *$V_1$) - likewise the edge lengths of Object 2 can be those of Object 1 multiplied by the same factor, and so Object 2 can be geometrically similar to Object 1.

**Object 1**                    **Object 2**

If Object 2 is loaded with the same value of external pressure and environmental temperature as for Object 1, then the stresses in Object 2 can be the same or similar as those found in Object 1, at corresponding points, and in some embodiments can be independent of a difference of materials used for Object 1 and Object 2.

For example, deflection of Object 2 can be equal to deflection of Object 1 multiplied by the scaling factor, such as for example when the materials are the same. If the materials are different then the deflection, $U_1$ and $U_2$, can be related by another factor if needed, such as for example by the expression $U_2$=factor * $U_1$ * $E_1/E_2$, where $E_1$ and $E_2$ are the Young's moduli for the materials in Objects 1 and 2, respectively.

Using such an approach, a package size and shape can be found that is suitable, and if a change to the size is desired, scaling can be applied to the dimensions to obtain a different sized package.

For example, the wall thickness, t, can be selected, which depends on the size of the package required and/or desired, and which may also depend upon the size of the electronics component(s) that are to be disposed inside the package.

With reference to Fig. 4, for example, the package 400 can be used to obtain the coefficient "a". The package 400, like previous packages, includes a first body 402, a second body 404, and a cavity 406. The package 400 can also include a seal material 407. It will be appreciated that the types of seal materials and electronic components discussed above can be applicable to the package 400. The package 400 can be a three dimensional simulated representation for example of any of the packages described above which may be of rectangular shape. In some embodiments, the package 400 has its bodies 402, 404 made of a ceramic material. Regarding the dimensions of package 400, which are shown by a quarter portion of an entire package, the height of the package can be the height of the first and second bodies 402, 404, defmed by $H_a$ and $H_b$. The width of the package is defined as $W_a$ and the length of the package is defined as $L_a$, both of which are represented in halves by $W_a/2$ and $L_a/2$ since a quarter of the package is shown. The cavity 406 can have dimensions defined by height $H_c$, width $W_c/2$, and length $L_c/2$. In one example, the cavity 406 of the package 400 can have length 6.35mm, height 1.37mm and width 2.05mm.

In the example of considering the largest face of the cavity from which to obtain a square root of the surface area, the length times width ($L_c * W_c$) is used, which in this case is the cavity bound by an inner surface of the either the first body 402 or the second body 404. The square root of this area is taken to determine the characteristic dimension, L. In this example, the coefficient, a, can then be obtained based on a scaled simulation, which in this case is a ratio of wall thickness to characteristic dimension, L, such that

$$t/L \geq (t/L)_{reference} = a.$$

For example, in Fig. 4, the reference coefficient $a = (t/L)_{reference} = 2.125/(2.05 \times 6.35)^{0.5} = 0.589$ or approximately 0.6. Thus, in one example for packaging an electronics component, such as a quartz oscillator, a reference coefficient, a, is based on a ratio that gives $(t/L)_{reference} \geq 0.6$, where L is the characteristic dimension based on the square root of an internal cavity face area. As above, in some embodiments such as in Fig. 4, the largest face within the volume of the cavity can be used, which can help ensure that, that the wall thickness, t, can be suitably selected.

It will be appreciated that the wall thickness, t, can be determined for packages of various materials including ceramic and/or metallic constructed packages. It will also be appreciated that other types of simulations and/or analyses may be employed to obtain the reference coefficient as needed. For example, for metals which can be considered relatively more ductile than ceramics, other failure criteria may be used to evaluate the reference coefficient of t/L or, a, such as by using for example Von mises criteria, which is material dependent in that the coefficient may be obtained that is less than a factor of the yield stress of the ductile material. For example, different types of steel which can have yield stresses ranging from 300MPa to 1000MPa for example, and can result in different coefficients.

It will also be appreciated that the wall thickness of packages herein at parts of the package other than at the seal surfaces can be determined based on the above simulation and modelling.

Regarding flatness of a package, one or more of the seal surfaces can include a characteristic dimension defined as flatness that is relative to a simulated plane of the one or more seal surfaces. The flatness can be based on one or more angle deviations along the one or more seal surfaces relative to the simulated plane. Each angle deviation is an angle taken between a portion of the one or more seal surfaces and the simulated plane, and is to be less than a threshold value.

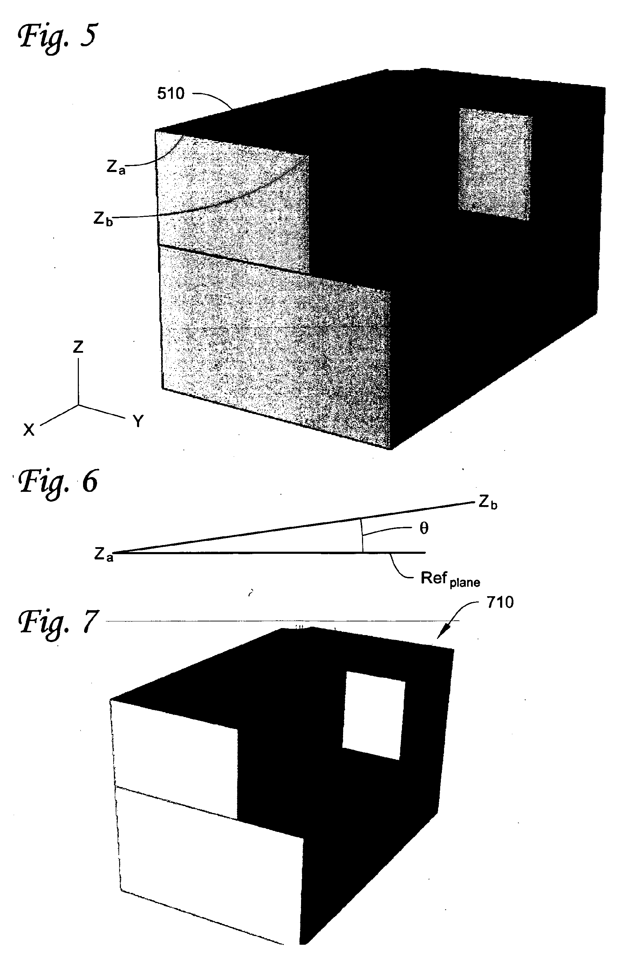

Figs. 5 to 8 illustrate how flatness of the seal surfaces can help distribution and/or transmission of force at the interface between the seal surfaces, and can help avoid concentrations of force, which may cause local high stresses and potential material failure. With reference to Fig. 5, the flatness of a portion 510 of the seal surface of a part of the package is shown, which is a bottom portion of the package 400 of Fig. 4. The portion 510 is between height points $Z_a$ and $Z_b$ that defines a portion of the seal surface that may have a deviation or out of flatness. The flatness of the portion 510 can be determined by taking a segment or plane between points $Z_a$ and $Z_b$ that has an angle $\theta$ relative to an imagined surface of the seal surface as if it were flat, such as a simulated reference plane $Ref_{plane}$ shown in Fig. 6. For example, Fig. 6 shows that out-of-flatness can be determined by the angle $\theta$ of the deviation of the plane made by $Z_a$ to $Z_b$, which is out of plane, or out of angle relative to the simulated plane $Ref_{plane}$.

In the portion 510 of Fig. 5, for example, a permissible angle between the actual sealing surface and the imagined surface can be within a threshold, for example, that does not exceed an angle of no more than about 0.14 degrees, or which can be equivalent for example to a slope/gradient of 2.5 microns in 1mm.

Fig. 7 illustrates the part 710 of the package shown in Fig. 5 and shows the pressure applied on a reduced portion of the package, which can be a non-uniform pressure applied on the package, such as for example from the first body 402 to the second body 404, as a result of the relative flatness characteristic of the seal surface. If the flatness is above a threshold then an external pressure can have a greater effect on the seal surfaces or joint of the package. Fig.

8 illustrates tension, or maximum principal stress on the seal surface 810 of the part of the package shown in Fig. 5 when a non-uniform mating pressure is applied. When the flatness is less than a threshold angle, for example, the maximum principle stress can then be within a threshold so as to avoid failure of the material of the package.

In some embodiments, the wall thickness dimension, t, and/or the flatness as described above can be selected so that the package has a maximum principal stress level of up to about 20 MPa.

As described, embodiments herein are directed to methods and packages to contain electronics component(s) so that they may be disposed in a subterranean environment and remain electrically functional in harsh environments. Such harsh environments can include conditions such as for example high pressures, high temperatures, high levels of shock and vibration, and various cycling among such conditions.

In some embodiments, the wall thickness dimension, t, and/or the flatness can be selected such that the electronics component(s) are electrically functional within the package subjected to an environment that has thermal and pressure cycling, the thermal cycling ranging from about -40°C to about 300°C and the pressure cycling ranging from about 0bar to about 3000bars.

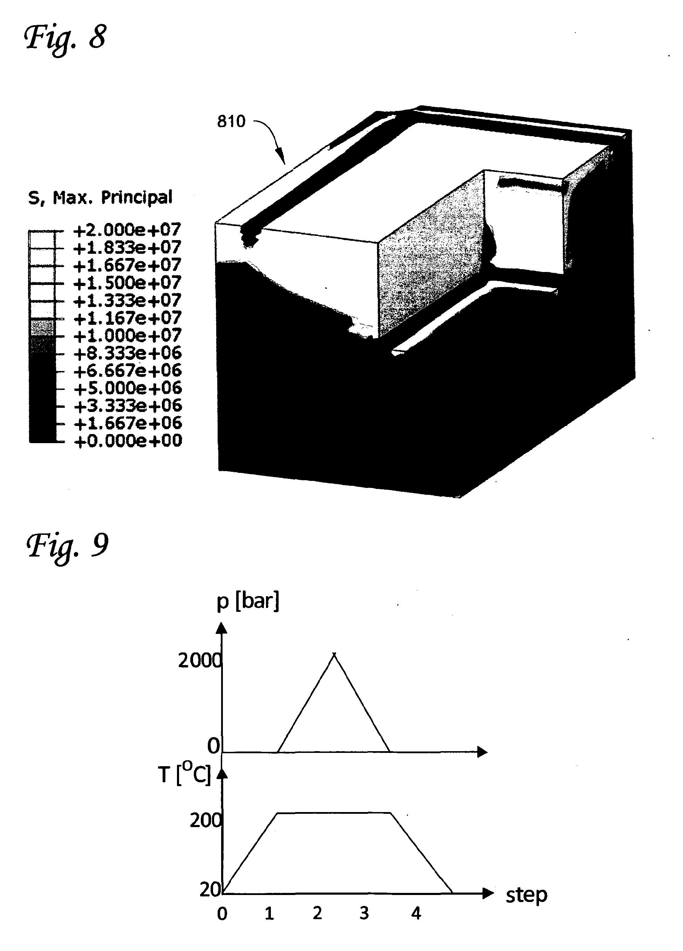

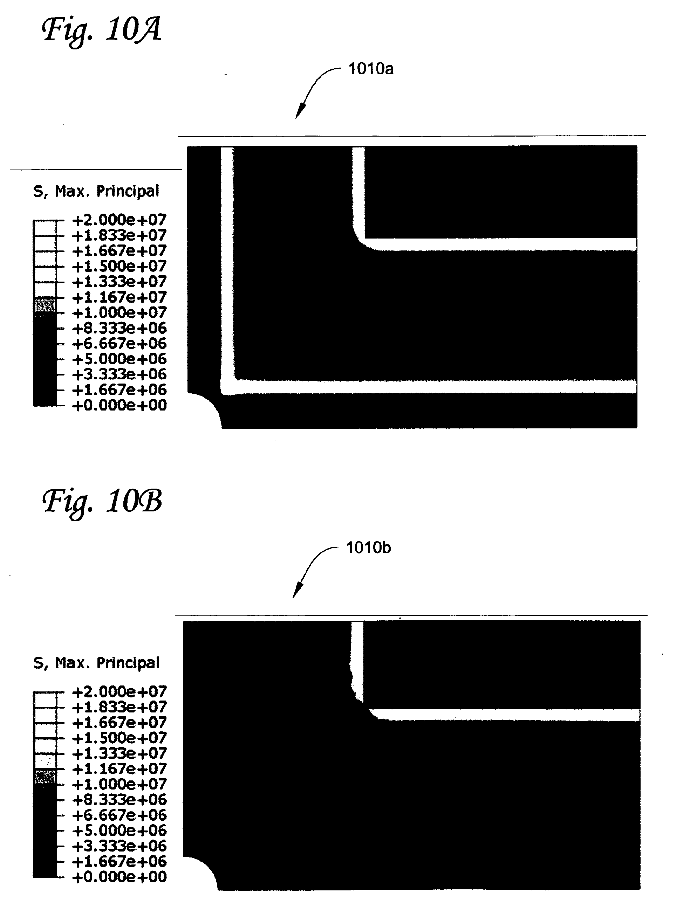

Fig. 9 illustrates an example of pressure cycling and temperature cycling on the package 400 of Fig. 4, and Figs. 10A-10D illustrate results of the pressure cycling and temperature cycling of Fig. 9. In the embodiment shown, package 400 has its bodies 402, 404 made of a ceramic material. In the example shown, the pressure cycling was from 0bar to 2000bars and the temperature cycling was from

With reference to Fig. 9, a simulation of one cycle on the package of Fig. 4 is shown including four steps of an increase of temperature, an increase in pressure and in temperature, a decrease in pressure, and then a decrease in temperature. While one cycle is shown, it will be appreciated that multiple cycles have been and could be tested, for example where such thermal and pressure cycling can include about 10 cycles, at least 10 cycles, or 10s of cycles. For example, packages herein, such as that of Fig. 4, have been tested up to 10 cycles according to the simulation of Fig. 9. With reference to the simulation, for example, when a thermal expansion coefficient is the same or similar for both the material of the package and the seal material, then changes in temperature will have little or no effect on the tension in the package, such as for example as steps 1 and 4. This is because the material of the package and seal material would be expected to expand and contract similarly. However, changes/cycling in pressure can cause tension in the package due to the seal material undergoing stresses, for example as in steps 2 and 3, as the seal material may be expected to react differently than the package material. When the thermal expansion coefficients are not the same, then changes in temperature and pressure can both affect the tension in the package material due to stresses in the seal material.

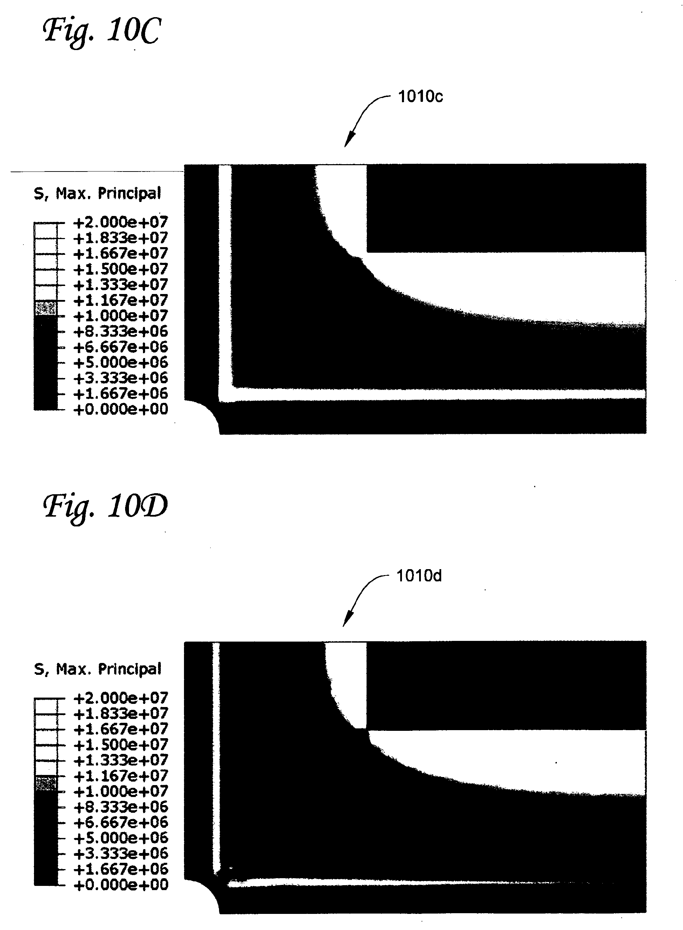

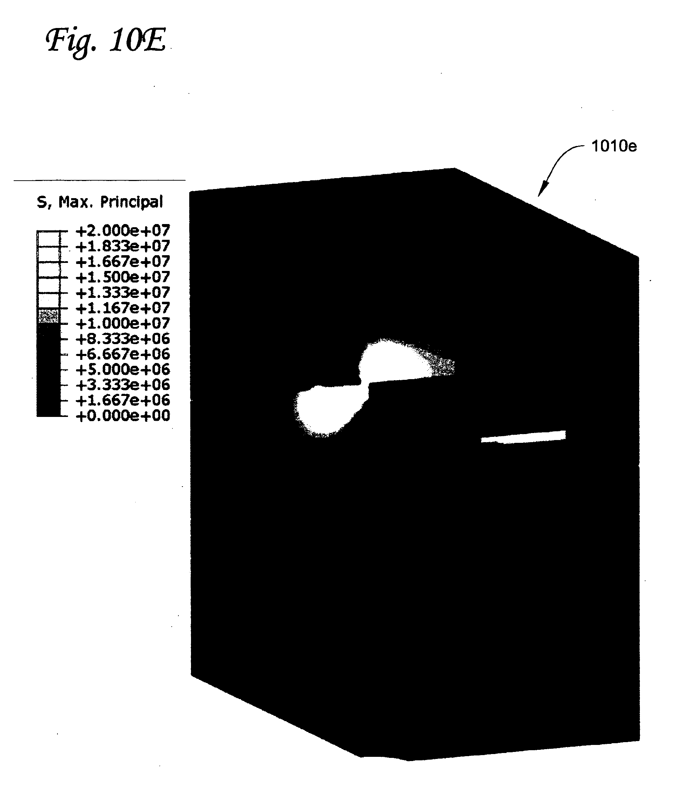

In Figures 10A to 10E, maximum principal stress is shown on a seal surface of a part of the package, such as the lower second body 404 of Fig. 4, which can represent the joint surface that is to seal with the upper first body 402. Fig 10A corresponds to step 1 of Fig. 9 and shows that there is some tension 1010a on the package due to differential expansion of the package material and the seal material, which may be formed by brazing for example. Fig. 10B corresponds to step 2 of Fig. 9 and shows that when pressure is applied the tension on the package can reduce 1010b. Fig 10C corresponds to step 3 of Fig. 9 and shows that after pressure is relaxed, but when high temperature is maintained, tension 1010c can be higher than in step 1, due to plastic deformation of the seal material, e.g. formed by brazing, as a result of earlier applied pressure. Fig 10D corresponds to step 4 and shows that after the temp is relaxed the tension 1010d reduces on some of the seal surface but is still higher than step 1, also due to plastic deformation of the seal material. Figs. 10A to 10D indicate for example that when choosing a seal material, consideration might be given to matching the thermal expansion coefficient of the seal (e.g. brazing material) and that of the package material. Fig. 10E shows the tension as in 10D but shows maximum principal stress 1010e on a quarter structure of the package, rather than on the lower second body 404 alone.

In some embodiments, as noted above, it will be appreciated that the wall thickness dimension, t, and/or the flatness can be selected so as to achieve a package that has a maximum principal stress level of up to about 20 MPa. This can be suitable for example, for a package made of a ceramic material.

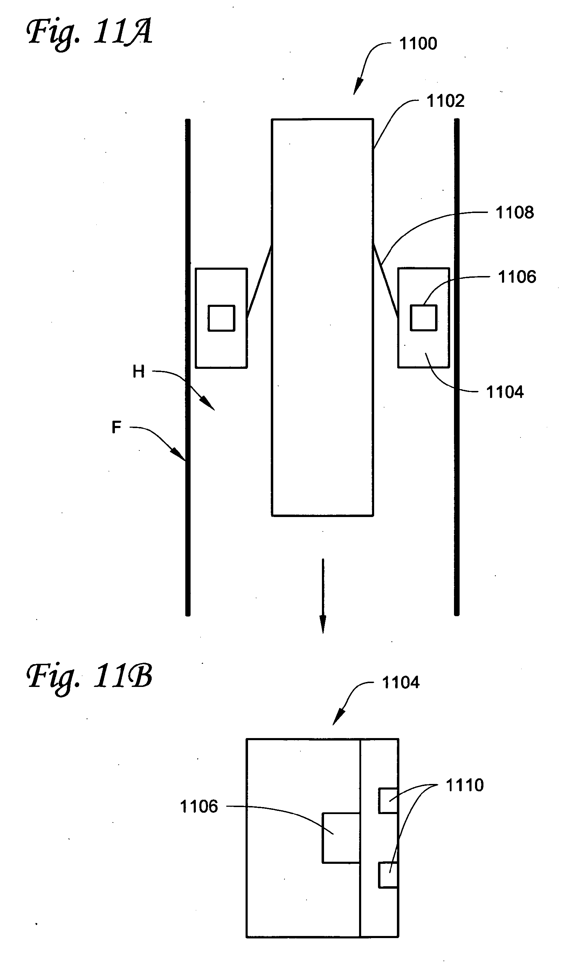

Fig. 11A illustrates a schematic example of a downhole tool 1100 in which can be contained a package 1106 that has electronics component(s). In the example shown, the downhole tool 1100 can include a tool cartridge 1102 connected to one or more components 1104 by supports 1108. The components 1104 can be adapted for contact against a subterranean formation F when the downhole tool 1100 is deployed downhole H.

Fig. 11B illustrates the component 1104 of the downhole tool 1100 with some additional detail. The component 1104 in some embodiments can be a pad that has electrodes or sensors 1110, which can be used for example in formation evaluation. The package 1106, which contains electronics component(s) therein can be disposed inside the pad, e.g. component 1104.

It will be appreciated that the downhole tool in which the packages herein can be contained, can include but are not limited to any of a wireline tool, a measurement-while-drilling (MWD) tool, a logging-while-drilling (LWD) tool, a coiled tubing tool, a testing tool, a completions tool, a production tool, or combinations thereof.

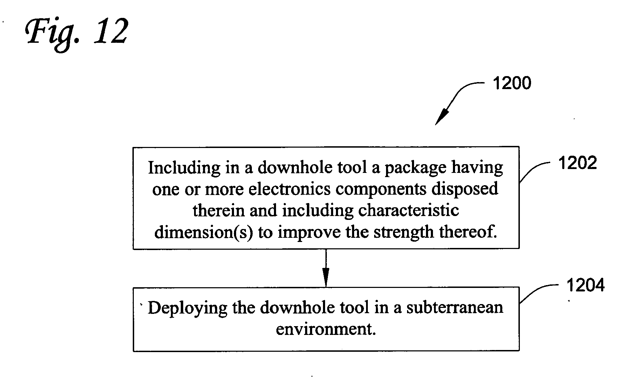

Fig. 12 illustrates one example of a method 1200 of disposing electronics in a subterranean environment. The method 1200 involves including in a downhole tool a package having one or more electronics components disposed therein and including characteristic dimension(s) to improve the strength thereof 1202, and deploying the downhole tool in a subterranean environment 1204.

It is noted that any of aspects 1-9 below can be combined with any of aspects 10-18 and any of aspects 1-9 and 10-18 can be combined with any of aspects 19 and 20.

1. A package having electronics disposed therein, the package comprising:

a first body that includes an outer surface and an inner surface;
a second body that includes an outer surface and an inner surface;
a cavity that is formed by the inner surface of the first body and the inner surface of the second body, the cavity having a characteristic dimension, L, that is a square root of a surface area taken from a face of the cavity;
one or more electronics components that are contained within the cavity; and
one or more seal surfaces on the first body and one or more seal surfaces on the second body that are arranged to seal the first body with the second body,
one or more of the seal surfaces include a wall thickness dimension, t, that extends toward the cavity from the outer surface of one or more of the first body and the second body, the wall thickness dimension, t, being determined by:

$$t \geq a * L,$$

where, a, is a coefficient.

2. The package of aspect 1, wherein the wall thickness dimension, t, is selected such that the one or more electronics components are electrically functional within the package subjected to an environment that has thermal and pressure cycling, the thermal cycling ranging from about -40°C to about 300°C, and the pressure cycling ranging from about 0bar to about 3000bars.

3. The package of aspect 1 or 2, wherein the wall thickness dimension, t, is selected so that the package has a maximum principal stress level of up to about 20 MPa.

4. The package of any of aspects 1 to 3, wherein the one or more electronics components include at least one of a crystal oscillator, a ceramic oscillator, an integrated circuit, and a sensor.

5. The package of any of aspects 1 to 4, wherein the package is adapted to be disposed inside a component of a downhole tool, the component is adapted for contact against a subterranean formation.

6. The package of any of aspects 1 to 5, further comprising one or more electrical conductors at least partially embedded in one or more of the first and second body that are a cofired material of at least one of ceramic and metal, the one or more electrical conductors to electrically connect the one or more electronics components to the exterior of the package.

7. The package of any of aspects 1 to 6, wherein one or more of the seal surfaces include a flatness relative to a simulated plane of the one or more seal surfaces, the flatness is based on one or more angle deviations along the one or more seal surfaces relative to the simulated plane, each angle deviation being an angle taken between a portion of the one or more seal surfaces and the simulated plane, and being less than a threshold value.

8. The package of any of aspects 1 to 7, further comprising a seal material between the one or more seal surfaces of the first and second bodies, the seal material extending to an exterior of the package and over a portion of the outer surface of one or more of the first and second bodies.

9. The package of aspects 1 to 8, further comprising one or more metal layers between the seal material and the one or more seal surfaces of the first and second bodies.

10. A package having electronics disposed therein, the package comprising:

a first body that includes an outer surface and an inner surface;
a second body that includes an outer surface and an inner surface;
a cavity that is formed by the inner surface of the first body and the inner surface of the second body;
one or more electronics components that are contained within the cavity; and
one or more seal surfaces on the first body and one or more seal surfaces on the second body that are arranged to seal the first body with the second body,
one or more of the seal surfaces including a flatness relative to a simulated plane of the one or more seal surfaces, the flatness is based on one or more angle deviations along the one or more seal surfaces relative to the simulated plane, each angle deviation being an angle taken between a portion of the one or more seal surfaces and the simulated plane, and being less than a threshold value.

11. The package of aspect 10, wherein the flatness is selected such that the one or more electronics components are electrically functional within the package subjected to an environment that has thermal and pressure cycling, the thermal cycling ranging from about-40°C to about 300°C, and the pressure cycling ranging from about 0bar to about 3000bars.

12. The package of aspect 10 or 11, wherein the flatness is selected so that the package has a maximum principal stress level of up to about 20 MPa.

13. The package of any of aspects 10 to 12, wherein the one or more electronics components include at least one of a crystal oscillator, a ceramic oscillator, an integrated circuit, and a sensor.

14. The package of any of aspects 10 to 13, wherein the package is adapted to be disposed inside a component of a downhole tool, the component is adapted for contact against a subterranean formation.

15. The package of any of aspects 10 to 14, further comprising one or more electrical conductors at least partially embedded in one or more of the first and second body that are a cofired material of at least one of ceramic and metal, the one or more electrical conductors to electrically connect the one or more electronics components to the exterior of the package.

16. The package of any of aspects 10 to 15, wherein the cavity has a characteristic dimension, L, that is a square root of a surface area taken from a face of the cavity, and
one or more of the seal surfaces include a wall thickness dimension, t, that extends toward the cavity from the outer surface of one or more of the first body and the second body, the wall thickness dimension, t, being determined by:

$$t \geq a * L,$$

where, a, is a coefficient.

17. The package of any of aspects 10 to 16, further comprising a seal material between the one or more seal surfaces of the first and second bodies, the seal material extending to an exterior of the package and over a portion of the outer surface of one or more of the first and second bodies.

18. The package of aspects 10 to 17, further comprising one or more metal layers between the seal material and the one or more seal surfaces of the first and second bodies.

19. A method of disposing electronics in a subterranean environment, comprising:

including in a downhole tool a package comprising a first body that has an outer surface and an inner surface; a second body that has an outer surface and an inner surface; a cavity that is formed by the inner surface of the first body and the inner surface of the second body; one or more electronics components that are contained within the cavity; and one or more seal surfaces on the first body and one or more seal surfaces on the second body that are arranged to seal the first body with the second body,
where the cavity has a characteristic dimension, L, that is a square root of a surface area taken from a face of the cavity, and one or more of the seal surfaces include a wall thickness dimension, t, that extends toward the cavity from the outer surface of one or more of the first body and the second body, and is determined by: $t \geq a$

* L, where, a, is a coefficient, and/or,

where one or more of the seal surfaces include a flatness relative to a simulated plane of the one or more seal surfaces, the flatness is based on one or more angle deviations along the one or more seal surfaces relative to the simulated plane, each angle deviation being an angle taken between a portion of the one or more seal surfaces and the simulated plane, and being less than a threshold value; and deploying the downhole tool in the subterranean environment.

20. The method of aspects 19, wherein the wall thickness dimension, t, and/or the flatness is selected such that the one or more electronics components are electrically functional within the package subjected to an environment that has thermal and pressure cycling, the thermal cycling ranging from about -40°C to about 300°C and the pressure cycling ranging from about 0bar to about 3000bars.

The disclosure may be embodied in other forms without departing from characteristics thereof. The embodiments disclosed in this disclosure are to be considered in all respects as illustrative and not limitative. The scope of the disclosure is indicated by the appended claims rather than by the foregoing description; and all changes which come within the meaning and range of equivalency of the claims are intended to be embraced therein.

## Claims

1. A package (10; 10b-g; 20; 30; 30b; 30d; 400; 1106) having electronics disposed therein, the package (10; 10b-g; 20; 30; 30b; 30d; 400; 1106) being configured to be disposed within a downhole tool (1100) and comprising:

    a first body (12; 22; 32; 32b; 32d; 402) that includes an outer surface and an inner surface;
    a second body (14; 24; 34; 34b; 34d; 404) that includes an outer surface and an inner surface;
    a cavity (16; 26; 36; 36b; 36d; 406) that is formed by the inner surface of the first body (12; 22; 32; 32b; 32d; 402) and the inner surface of the second body (14; 24; 34; 34b; 34d; 404), the cavity (16; 26; 36; 36b; 36d; 406) having a characteristic dimension, L, that is a square root of a surface area taken from a face of the cavity (16; 26; 36; 36b; 36d; 406);
    one or more electronics components (18; 28; 38; 38b; 38d) that are contained within the cavity (16; 26; 36; 36b; 36d); and
    one or more seal surfaces (13; 23; 33; 33b; 33d) on the first body (12; 22; 32; 32b; 32d; 402) and one or more seal surfaces (15; 25; 35; 35b; 35d) on the second body (14; 24; 34; 34b; 34d; 404) that are arranged to seal the first body (12; 22; 32; 32b; 32d; 402) with the second body (14; 24; 34; 34b; 34d; 404);
    wherein one or more of the seal surfaces (13, 15; 23, 25; 33, 35; 35b; 35d) include a wall thickness dimension, t, that extends toward the cavity (16; 26; 36; 36b; 36d; 406) from the outer surface of one or more of the first body (12; 22; 32; 32b; 32d; 402) and the second body (14; 24; 34; 34b; 34d; 404), the wall thickness dimension, t, being determined by:

$$t \geq a * L$$

    where a is a coefficient and the face of the cavity is a surface defining a boundary of the cavity (16; 26; 36; 36b; 36d; 406) or an imaginary plane across the volume of the cavity (16; 26; 36; 36b; 36d; 406);
    wherein the coefficient a, the wall thickness dimension t, or both, are selected based on parameters of the package and conditions expected in a downhole environment, where the parameters and conditions comprise stress, deflection, pressure, temperature, package size, package shape, a size of the one or more electronics components, a material of the package, or combinations thereof; and
    wherein the selected coefficient a or the selected wall thickness dimension t results in the package being suitable for packaging the one or more electronic components, such that the one or more electronic components remain electrically functional when the package is disposed in the downhole environment.

2. The package (10; 10b-g; 20; 30; 30b; 30d; 1106) of claim 1, wherein the wall thickness dimension, t, is selected such that the one or more electronics components (18; 28; 38; 38b; 38d) are electrically functional within the package (10; 10b-g; 20; 30; 30b; 30d; 1106) subjected to an environment that has thermal and pressure cycling, the thermal cycling ranging from about -40°C to about 300°C, and the pressure cycling ranging from about 0bar to about 3000bars.

3. The package (10; 10b-g; 20; 30; 30b; 30d; 1106) of claim 1 or 2, wherein the wall thickness dimension, t, is selected so that the package has a maximum principal stress level of up to about 20 MPa.

4. The package (10; 10b-g; 20; 30; 30b; 30d; 1106) of any of claims 1 to 3, wherein the one or more electronics components (18; 28; 38; 38b; 38d) include at least one of a crystal oscillator, a ceramic oscillator, an integrated circuit, and a sensor.

5. The package (10; 10b-g; 20; 30; 30b; 30d; 1106) of any of claims 1 to 4, wherein the package (10; 10b-g; 20; 30; 30b; 30d; 1106) is adapted to be disposed inside a component of a downhole tool (1100), the component being adapted for contact against a subterranean formation.

6. The package (10; 30b) of any of claims 1 to 5, further comprising one or more electrical conductors (11; 31b) at least partially embedded in one or more of the first (12; 32b) and second body (14; 34b) that are a cofired material of at least one of ceramic and metal, the one or more electrical conductors (11; 31b) electrically connecting the one or more electronics components (18; 38b) to the outer surface of one or more of the first body (12; 32b) and the second body (14; 34b).

7. The package (400) of any of claims 1 to 6, wherein one or more of the seal surfaces include a flatness relative to a simulated plane ($\text{Ref}_{plane}$) of the one or more seal surfaces, the flatness being based on one or more angle deviations along the one or more seal surfaces relative to the simulated plane ($\text{Ref}_{plane}$), each angle deviation being an angle ($\theta$) taken between a portion of the one or more seal surfaces and the simulated plane ($\text{Ref}_{plane}$), and being less than a threshold value.

8. The package (10c; 10e) of any of claims 1 to 7, further comprising a seal material (17c; 17e) between the one or more seal surfaces of the first and second bodies (12, 14), the seal material (17c; 17e) extending to an exterior of the package (10c; 10e) and over a portion of the outer surface of one or more of the first and second bodies (12, 14).

9. The package (10c) of claim 8, further comprising one or more metal layers (19c) between the seal material (17c) and the one or more seal surfaces of the first and second bodies (12, 14).

10. A method of manufacturing a package (10; 10b-g; 20; 30; 30b; 30d; 400; 1106) suitable for being configured in a downhole tool (1100), the method comprising:

> providing a first body (12; 22; 32; 32b; 32d; 402) having an outer surface and an inner surface;
> providing a second body (14; 24; 34; 34b; 34d; 404) having an outer surface and an inner surface;
> coupling the first body (12; 22; 32; 32b; 32d; 402) with the second body (14; 24; 34; 34b; 34d; 404) to form a cavity (16; 26; 36; 36b; 36d; 406) that is formed by the inner surface of the first body (12; 22; 32; 32b; 32d; 402) and the inner surface of the second body (14; 24; 34; 34b; 34d; 404);
> disposing one or more electronics components (18; 28; 38; 38b; 38d) within the cavity (16; 26; 36; 36b; 36d; 406); disposing one or more seal surfaces (13; 23; 33; 33b; 33d) on the first body (12; 22; 32; 32b; 32d; 402) and one or more seal surfaces (15; 25; 35; 35b; 35d) on the second body (14; 24; 34; 34b; 34d; 404) that are arranged to seal the first body (12; 22; 32; 32b; 32d; 402) with the second body (14; 24; 34; 34b; 34d; 404);
> where the cavity (16; 26; 36; 36b; 36d; 406) has a characteristic dimension, L, that is a square root of a surface area taken from a face of the cavity (16; 26; 36; 36b; 36d; 406), and one or more of the seal surfaces (13, 15; 23, 25; 33, 35; 35b; 35d) include a wall thickness dimension, t, that extends toward the cavity (16; 26; 36; 36b; 36d; 406) from the outer surface of one or more of the first body (12; 22; 32; 32b; 32d; 402) and the second body (14; 24; 34; 34b; 34d; 404), and is determined by:

$$t \geq a * L,$$

> where a is a coefficient and the face of the cavity (16; 26; 36; 36b; 36d; 406) is a surface defining a boundary of the cavity (16; 26; 36; 36b; 36d; 406) or an imaginary plane across the volume of the cavity (16; 26; 36; 36b; 36d; 406); and
> selecting the coefficient a, the wall thickness dimension t, or both, based on parameters of the package and conditions expected in a downhole environment, where the parameters and conditions comprise stress, deflection, pressure, temperature, package size, package shape, a size of the one or more electronics components, a material of the package, or combinations thereof, wherein the selected coefficient a or the selected wall thickness dimension t results in the package being suitable for packaging the one or more electronic components, such that the one or more electronic components remain electrically functional when the package is disposed in the downhole environment

11. The method of claim 10, wherein the wall thickness dimension, t, is selected such that the one or more electronics components (18; 28; 38; 38b; 38d) are electrically functional within the package (10; 10b-g; 20; 30; 30b; 30d; 1106) when subjected to an environment that has thermal and pressure cycling, the thermal cycling ranging from about -40°C to about 300°C and the pressure cycling ranging from about 0bar to about 3000bars.

**Patentansprüche**

1. Baugruppe (10; 10b-g; 20; 30; 30b; 30d; 400; 1106), die in der Elektronik angeordnet ist, wobei die Baugruppe (10; 10b-g; 20; 30; 30b; 30d; 400; 1106) so konfiguriert ist, dass sie innerhalb eines Bohrlochwerkzeugs (1100) angeordnet ist und umfasst:

einen ersten Körper (12; 22; 32; 32b; 32d; 402), der eine Außenoberfläche und eine Innenoberfläche enthält; einen zweiten Körper (14; 24; 34; 34b; 34d; 404), der eine Außenoberfläche und eine Innenoberfläche enthält; einen Hohlraum (16; 26; 36; 36b; 36d; 406), der durch die Innenoberfläche des ersten Körpers (12; 22; 32; 32b; 32d; 402) und durch die Innenoberfläche des zweiten Körpers (14; 24; 34; 34b; 34d; 404) gebildet ist, wobei der Hohlraum (16; 26; 36; 36b; 36d; 406) eine charakteristische Dimension, L, aufweist, die die Quadratwurzel aus einem Flächeninhalt, gebildet von einer Fläche des Hohlraums (16; 26; 36; 36b; 36d; 406), ist; ein oder mehrere elektronische Bauelemente (18; 28; 38; 38b; 38d), die innerhalb des Hohlraums (16; 26; 36; 36b; 36d) enthalten sind; und eine oder mehrere Dichtungsflächen (13; 23; 33; 33b; 33d) an dem ersten Körper (12; 22; 32; 32b; 32d; 402) und eine oder mehrere Dichtungsflächen (15; 25; 35; 35b; 35d) an dem zweiten Körper (14; 24; 34; 34b; 34d; 404), die so ausgelegt sind, dass sie den ersten Körper (12; 22; 32; 32b; 32d; 402) mit dem zweiten Körper (14; 24; 34; 34b; 34d; 404) abdichten; wobei eine oder mehrere der Dichtungsflächen (13, 15; 23, 25; 33, 35; 35b; 35d) eine Wanddickedimension, t, enthalten, die von der Außenoberfläche des ersten Körpers (12; 22; 32; 32b; 32d; 402) und/oder des zweiten Körpers (14; 24; 34; 34b; 34d; 404) in Richtung des Hohlraums (16; 26; 36; 36b; 36d; 406) verläuft, wobei die Wanddickedimension, t, bestimmt ist durch:

$$t \geq a * L,$$

wobei a ein Koeffizient ist und die Fläche des Hohlraums eine Oberfläche ist, die eine Begrenzung des Hohlraums (16; 26; 36; 36b; 36d; 406) definiert, oder eine gedachte Ebene durch das Volumen des Hohlraums (16; 26; 36; 36b; 36d; 406) ist; wobei der Koeffizient a und/oder die Wanddickedimension t auf der Grundlage von Parametern der Baugruppe und von in einer Bohrlochumgebung erwarteten Bedingungen gewählt sind, wobei die Parameter und Bedingungen die Spannung, die Durchbiegung, den Druck, die Temperatur, die Baugruppengröße, die Baugruppenform, eine Größe des einen oder der mehreren elektronischen Bauelemente, ein Material der Baugruppe oder Kombinationen davon umfassen; und wobei der gewählte Koeffizient a oder die gewählte Wanddickedimension t dazu führt, dass die Baugruppe dafür geeignet ist, das eine oder die mehreren elektronischen Bauelemente in der Weise in der Baugruppe zu montieren, dass das eine oder die mehreren elektronischen Bauelemente elektrisch funktionsfähig bleiben, wenn die Baugruppe in der Bohrlochumgebung angeordnet ist.

2. Baugruppe (10; 10b-g; 20; 30; 30b; 30d; 1106) nach Anspruch 1, wobei die Wanddickedimension, t, in der Weise gewählt ist, dass das eine oder die mehreren elektronischen Bauelemente (18; 28; 38; 38b; 38d) innerhalb der Baugruppe (10; 10b-g; 20; 30; 30b; 30d; 1106) elektrisch funktionsfähig sind, wenn sie einer Umgebung ausgesetzt sind, die zyklische Temperatur- und Druckänderungen aufweist, wobei die zyklische Temperaturänderung in dem Bereich von etwa -40°C bis etwa 300°C liegt und wobei die zyklische Druckänderung in dem Bereich von etwa 0 Bar bis etwa 3000 Bar liegt.

**3.** Baugruppe (10; 10b-g; 20; 30; 30b; 30d; 1106) nach Anspruch 1 oder 2, wobei die Wanddickedimension, t, in der Weise gewählt ist, dass die Baugruppe ein maximales Hauptspannungsniveau von bis zu etwa 20 MPa aufweist.

**4.** Baugruppe (10; 10b-g; 20; 30; 30b; 30d; 1106) nach einem der Ansprüche 1 bis 3, wobei das eine oder die mehreren elektronischen Bauelemente (18; 28; 38; 38b; 38d) einen Quarzoszillator und/oder einen Keramikoszillator und/oder einen integrierten Schaltkreis und/oder einen Sensor enthalten.

**5.** Baugruppe (10; 10b-g; 20; 30; 30b; 30d; 1106) nach einem der Ansprüche 1 bis 4, wobei die Baugruppe (10; 10b-g; 20; 30; 30b; 30d; 1106) dafür ausgelegt ist, innerhalb eines Bauelements eines Bohrlochwerkzeugs (1100) angeordnet zu werden, wobei das Bauelement für den Kontakt gegen eine unterirdische Formation ausgelegt ist.

**6.** Baugruppe (10; 30b) nach einem der Ansprüche 1 bis 5, die ferner einen oder mehrere wenigstens teilweise in den ersten (12; 32b) und/oder in den zweiten (14; 34b) Körper eingebettete elektrische Leiter (11; 31b) umfasst, die ein Cofired-Material wenigstens aus einer Keramik und einem Metall sind, wobei der eine oder die mehreren elektrischen Leiter (11; 31b) das eine oder die mehreren elektronischen Bauelemente (18; 38b) mit der Außenoberfläche des ersten Körpers (12; 32b) und/oder des zweiten Körpers (14; 34b) elektrisch verbinden.

**7.** Baugruppe (400) nach einem der Ansprüche 1 bis 6, wobei eine oder mehrere der Dichtungsflächen relativ zu der simulierten Ebene (Ref$_{plane}$) der einen oder mehreren Dichtungsflächen eine Ebenheit enthalten, wobei die Ebenheit auf einer oder auf mehreren Winkelabweichungen entlang der einen oder der mehreren Dichtungsflächen relativ zu der simulierten Ebene (Ref$_{plane}$) beruht, wobei jede Winkelabweichung ein zwischen einem Abschnitt der einen oder der mehreren Dichtungsflächen und der simulierten Ebene (Ref$_{plane}$) gebildeter Winkel ($\theta$) ist und kleiner als ein Schwellenwert ist.

**8.** Baugruppe (10c; 10e) nach einem der Ansprüche 1 bis 7, die ferner zwischen der einen oder den mehreren Dichtungsflächen des ersten und des zweiten Körpers (12, 14) ein Dichtungsmaterial (17c; 17e) umfasst, wobei das Dichtungsmaterial (17c; 17e) aus der Baugruppe (10c; 10e) heraus und über einen Abschnitt der Außenoberfläche des ersten und/oder des zweiten Körpers (12, 14) verläuft.

**9.** Baugruppe (10c) nach Anspruch 8, die ferner zwischen dem Dichtungsmaterial (17c) und der einen oder den mehreren Dichtungsflächen des ersten und des zweiten Körpers (12, 14) eine oder mehrere Metallschichten (19c) umfasst.

**10.** Verfahren zum Herstellen einer Baugruppe (10; 10b-g; 20; 30; 30b; 30d; 400; 1106), die dazu geeignet ist, in einem Bohrlochwerkzeug (1100) konfiguriert zu werden, wobei das Verfahren umfasst:

Bereitstellen eines ersten Körpers (12; 22; 32; 32b; 32d; 402), der eine Außenoberfläche und eine Innenoberfläche aufweist;
Bereitstellen eines zweiten Körpers (14; 24; 34; 34b; 34d; 404), der eine Außenoberfläche und eine Innenoberfläche aufweist;
Koppeln des ersten Körpers (12; 22; 32; 32b; 32d; 402) mit dem zweiten Körper (14; 24; 34; 34b; 34d; 404) in der Weise, dass ein Hohlraum (16; 26; 36; 36b; 36d; 406) gebildet wird, der durch die Innenoberfläche des ersten Körpers (12; 22; 32; 32b; 32d; 402) und durch die Innenoberfläche des zweiten Körpers (14; 24; 34; 34b; 34d; 404) gebildet ist;
Anordnen eines oder mehrerer elektronischer Bauelemente (18; 28; 38; 38b; 38d) innerhalb des Hohlraums (16; 26; 36; 36b; 36d; 406);
Anordnen einer oder mehrerer Dichtungsflächen (13; 23; 33; 33b; 33d) an dem ersten Körper (12; 22; 32; 32b; 32d; 402) und einer oder mehrerer Dichtungsflächen (15; 25; 35; 35b; 35d) an dem zweiten Körper (14; 24; 34; 34b; 34d; 404), die so ausgelegt sind, dass sie den ersten Körper (12; 22; 32; 32b; 32d; 402) mit dem zweiten Körper (14; 24; 34; 34b; 34d; 404) abdichten;
wobei der Hohlraum (16; 26; 36; 36b; 36d; 406) eine charakteristische Dimension, L, aufweist, die eine Quadratwurzel aus einem Flächeninhalt, gebildet von einer Fläche des Hohlraums (16; 26; 36; 36b; 36d; 406), ist, und wobei eine oder mehrere der Dichtungsflächen (13, 15; 23, 25; 33, 35; 35b; 35d) eine Wanddickedimension, t, enthalten, die von der Außenoberfläche des ersten Körpers (12; 22; 32; 32b; 32d; 402) und/oder des zweiten Körpers (14; 24; 34; 34b; 34d; 404) in Richtung des Hohlraums (16; 26; 36; 36b; 36d; 406) verläuft und die bestimmt ist durch:

$$t \geq a * L,$$

wobei a ein Koeffizient ist und die Fläche des Hohlraums (16; 26; 36; 36b; 36d; 406) eine Oberfläche ist, die eine Begrenzung des Hohlraums (16; 26; 36; 36b; 36d; 406) definiert, oder eine gedachte Ebene durch das Volumen des Hohlraums (16; 26; 36; 36b; 36d; 406) ist; und

Wählen des Koeffizienten a und/oder der Wanddickedimension t auf der Grundlage von Parametern der Baugruppe und von in einer Bohrlochumgebung erwarteten Bedingungen, wobei die Parameter und Bedingungen die Spannung, die Durchbiegung, den Druck, die Temperatur, die Baugruppengröße, die Baugruppenform, eine Größe des einen oder der mehreren elektronischen Bauelemente, ein Material der Baugruppe oder Kombinationen davon umfassen, wobei der gewählte Koeffizient a oder die gewählte Wanddickedimension t dazu führt, dass die Baugruppe dafür geeignet ist, das eine oder die mehreren elektronischen Bauelemente in der Weise in der Baugruppe zu montieren, dass das eine oder die mehreren elektronischen Bauelemente elektrisch funktionsfähig bleiben, wenn die Baugruppe in der Bohrlochumgebung angeordnet ist.

**11.** Verfahren nach Anspruch 10, wobei die Wanddickedimension, t, in der Weise gewählt wird, dass das eine oder die mehreren elektronischen Bauelemente (18; 28; 38; 38b; 38d) innerhalb der Baugruppe (10; 10b-g; 20; 30; 30b; 30d; 1106) elektrisch funktionsfähig sind, wenn sie einer Umgebung ausgesetzt sind, die zyklische Temperatur- und Druckänderungen aufweist, wobei die zyklische Temperaturänderung in dem Bereich von etwa -40°C bis etwa 300°C liegt und wobei die zyklische Druckänderung in dem Bereich von 0 Bar bis etwa 3000 Bar liegt.

## Revendications

**1.** Paquet (10 ; 10b-g ; 20 ; 30 ; 30b ; 30d ; 400 ; 1106) dans lequel est disposée de l'électronique, le paquet (10 ; 10b-g ; 20 ; 30 ; 30b ; 30d ; 400 ; 1106) étant configuré pour être disposé au sein d'un outil de fond de trou (1100) et comprenant :

un premier corps (12 ; 22 ; 32 ; 32b ; 32d ; 402) qui inclut une surface externe et une surface interne ;
un second corps (14 ; 24 ; 34 ; 34b ; 34d ; 404) qui inclut une surface externe et une surface interne ;
une cavité (16 ; 26 ; 36 ; 36b ; 36d ; 406) qui est formée par la surface interne du premier corps (12 ; 22 ; 32 ; 32b ; 32d ; 402) et la surface interne du second corps (14 ; 24 ; 34 ; 34b ; 34d ; 404), la cavité (16 ; 26 ; 36 ; 36b ; 36d ; 406) ayant une dimension caractéristique, L, qui est une racine carrée d'une superficie prise depuis une face de la cavité (16 ; 26 ; 36 ; 36b ; 36d ; 406) ;
un ou plusieurs composants d'électronique (18 ; 28 ; 38 ; 38b ; 38d) qui sont contenus au sein de la cavité (16 ; 26 ; 36 ; 36b ; 36d) ; et
une ou plusieurs surfaces de joint (13 ; 23 ; 33 ; 33b ; 33d) sur le premier corps (12 ; 22 ; 32 ; 32b ; 32d ; 402) et une ou plusieurs surfaces de joint (15 ; 25 ; 35 ; 35b ; 35d) sur le second corps (14 ; 24 ; 34 ; 34b ; 34d ; 404) qui sont agencées pour sceller le premier corps (12 ; 22 ; 32 ; 32b ; 32d ; 402) avec le second corps (14 ; 24 ; 34 ; 34b ; 34d ; 404) ;
dans lequel une ou plusieurs des surfaces de joint (13, 15 ; 23, 25 ; 33, 35 ; 35b ; 35d) incluent une dimension de paroi d'épaisseur, t, qui s'étend vers la cavité (16 ; 26 ; 36 ; 36b ; 36d ; 406) depuis la surface externe d'un ou plusieurs du premier corps (12 ; 22 ; 32 ; 32b ; 32d ; 402) et du second corps (14 ; 24 ; 34 ; 34b ; 34d ; 404), la dimension d'épaisseur de paroi, t, étant déterminée par :

$$t \geq a * L$$

où a est un coefficient et la face de la cavité est une surface définissant une frontière de la cavité (16 ; 26 ; 36 ; 36b ; 36d ; 406) ou un plan imaginaire à travers le volume de la cavité (16 ; 26 ; 36 ; 36b ; 36d ; 406) ;
dans lequel le coefficient a, la dimension d'épaisseur de paroi t, ou les deux, sont choisis en se basant sur des paramètres du paquet et des conditions attendues dans un environnement de fond de trou, où les paramètres et conditions comprennent contrainte, déflexion, pression, température, taille de paquet, forme de paquet, une taille des un ou plusieurs composants d'électronique, un matériau du paquet, ou leurs combinaisons ; et
dans lequel le coefficient a sélectionné ou la dimension d'épaisseur de paroi t sélectionnée amène le paquet à convenir à l'emballage des un ou plusieurs composants d'électronique, de telle sorte que les un ou plusieurs composants d'électronique restent électriquement fonctionnels lorsque le paquet est disposé dans l'environnement de fond de trou.

2. Paquet (10 ; 10b-g ; 20 ; 30 ; 30b ; 30d ; 1106) selon la revendication 1, dans lequel la dimension d'épaisseur de paroi t, est choisie de telle sorte que les un ou plusieurs composants d'électronique (18 ; 28 ; 38 ; 38b ; 38d) soient électriquement fonctionnels au sein du paquet (10 ; 10b-g ; 20 ; 30 ; 30b ; 30d ; 1106) soumis à un environnement qui a un cyclage thermique et de pression, le cyclage thermique allant d'environ -40 °C à environ 300 °C, et le cyclage de pression allant d'environ 0 bar à environ 3 000 bars.

3. Paquet (10 ; 10b-g ; 20 ; 30 ; 30b ; 30d ; 1106) selon la revendication 1 ou 2, dans lequel la dimension d'épaisseur de paroi, t, est choisie de telle sorte que le paquet ait un niveau de contrainte principale maximal allant jusqu'à environ 20 MPa.

4. Paquet (10 ; 10b-g ; 20 ; 30 ; 30b ; 30d ; 1106) selon l'une quelconque des revendications 1 à 3, dans lequel les un ou plusieurs composants d'électronique (18 ; 28 ; 38 ; 38b ; 38d) incluent au moins l'un d'un oscillateur à cristaux, d'un oscillateur céramique, d'un circuit intégré, et d'un capteur.

5. Paquet (10 ; 10b-g ; 20 ; 30 ; 30b ; 30d ; 1106) selon l'une quelconque des revendications 1 à 4, dans lequel le paquet (10 ; 10b-g ; 20 ; 30 ; 30b ; 30d ; 1106) est adapté pour être disposé à l'intérieur d'un composant d'un outil de fond de trou (1100), le composant étant adapté pour un contact contre une formation souterraine.

6. Paquet (10 ; 30b) selon l'une quelconque des revendications 1 à 5, comprenant en outre un ou plusieurs conducteurs électriques (11 ; 31b) au moins partiellement noyés dans un ou plusieurs du premier (12 ; 32b) et du second (14 ; 34b) corps qui sont un matériau co-mis à feu d'au moins l'un d'une céramique et d'un métal, les un ou plusieurs conducteurs électriques (11 ; 31b) connectant électriquement les un ou plusieurs composants d'électronique (18 ; 38b) à la surface externe d'un ou plusieurs du premier corps (12 ; 32b) et du second corps (14 ; 34b).

7. Paquet (400) selon l'une quelconque des revendications 1 à 6, dans lequel une ou plusieurs des surfaces de joint incluent une planéité relative à un plan simulé ($Ref_{plan}$) des une ou plusieurs surfaces de joint, la planéité étant basée sur une ou plusieurs écarts d'angle le long des une ou plusieurs surfaces de joint par rapport au plan simulé ($Ref_{plan}$), chaque écart d'angle étant un angle ($\theta$) pris entre une partie des une ou plusieurs surfaces de joint et le plan simulé ($Ref_{plan}$), et étant inférieur à une valeur seuil.

8. Paquet (10c ; 10e) selon l'une quelconque des revendications 1 à 7, comprenant en outre un matériau de joint (17c ; 17e) entre les une ou plusieurs surfaces de joint des premier et second corps (12, 14), le matériau de joint (17c ; 17e) s'étendant vers un extérieur du paquet (10c ; 10e) et sur une partie de la surface externe d'un ou plusieurs des premier et second corps (12, 14).

9. Paquet (10c) selon la revendication 8, comprenant en outre une ou plusieurs couches de métal (19c) entre le matériau de joint (17c) et les une ou plusieurs surfaces de joint des premier et second corps (12, 14).

10. Procédé de fabrication d'un paquet (10 ; 10b-g ; 20 ; 30 ; 30b ; 30d ; 400 ; 1106) convenant pour être configuré dans un outil de fond de trou (1100), le procédé comprenant :

la fourniture d'un premier corps (12 ; 22 ; 32 ; 32b ; 32d ; 402) ayant une surface externe et une surface interne ;
la fourniture d'un second corps (14 ; 24 ; 34 ; 34b ; 34d ; 404) ayant une surface externe et une surface interne ;
le couplage du premier corps (12 ; 22 ; 32 ; 32b ; 32d ; 402) avec le second corps (14 ; 24 ; 34 ; 34b ; 34d ; 404) pour former une cavité (16 ; 26 ; 36 ; 36b ; 36d ; 406) qui est formée par la surface interne du premier corps (12 ; 22 ; 32 ; 32b ; 32d ; 402) et la surface interne du second corps (14 ; 24 ; 34 ; 34b ; 34d ; 404) ;
la disposition d'un ou plusieurs composants d'électronique (18 ; 28 ; 38 ; 38b ; 38d) au sein de la cavité (16 ; 26 ; 36 ; 36b ; 36d ; 406) ;
la disposition d'une ou plusieurs surfaces de joint (13 ; 23 ; 33 ; 33b ; 33d) sur le premier corps (12 ; 22 ; 32 ; 32b ; 32d ; 402) et d'une ou plusieurs surfaces de joint (15 ; 25 ; 35 ; 35b ; 35d) sur le second corps (14 ; 24 ; 34 ; 34b ; 34d ; 404) qui sont agencées pour sceller le premier corps (12 ; 22 ; 32 ; 32b ; 32d ; 402) avec le second corps (14 ; 24 ; 34 ; 34b ; 34d ; 404) ;
où la cavité (16 ; 26 ; 36 ; 36b ; 36d ; 406) a une dimension caractéristique, L, qui est une racine carrée d'une superficie prise à partir d'une face de la cavité (16 ; 26 ; 36 ; 36b ; 36d ; 406), et une ou plusieurs des surfaces de joint (13, 15 ; 23, 25 ; 33, 35 ; 35b ; 35d) incluent une dimension d'épaisseur de paroi, t, qui s'étend vers la cavité (16 ; 26 ; 36 ; 36b ; 36d ; 406) depuis la surface externe d'un ou plusieurs du premier corps (12 ; 22 ; 32 ; 32b ; 32d ; 402) et du second corps (14 ; 24 ; 34 ; 34b ; 34d ; 404), et est déterminée par :

$$t \geq a * L,$$

où a est un coefficient et la face de la cavité (16 ; 26 ; 36 ; 36b ; 36d ; 406) est une surface définissant une frontière de la cavité (16 ; 26 ; 36 ; 36b ; 36d ; 406) ou un plan imaginaire à travers le volume de la cavité (16 ; 26 ; 36 ; 36b ; 36d ; 406) ; et
la sélection du coefficient a, de la dimension d'épaisseur de paroi t, ou des deux, en se basant sur des paramètres du paquet et des conditions attendues dans un environnement de fond de trou, où les paramètres et conditions comprennent contrainte, déflexion, pression, température, taille de paquet, forme de paquet, une taille des un ou plusieurs composants d'électronique, un matériau du paquet, ou leurs combinaisons, dans lequel le coefficient a sélectionné ou la dimension d'épaisseur de paroi t sélectionnée amène le paquet à convenir à l'emballage des un ou plusieurs composants d'électronique, de telle sorte que les un ou plusieurs composants d'électronique restent électriquement fonctionnels lorsque le paquet est disposé dans l'environnement de fond de trou.

11. Procédé selon la revendication 10, dans lequel la dimension d'épaisseur de paroi, t, est sélectionnée de telle sorte que les un ou plusieurs composants d'électronique (18 ; 28 ; 38 ; 38b ; 38d) soient électriquement fonctionnels au sein du paquet (10 ; 10b-g ; 20 ; 30 ; 30b ; 30d ; 1106) lorsqu'ils sont soumis à un environnement qui a un cyclage thermique et de pression, le cyclage thermique allant d'environ -40 °C à environ 300 °C et le cyclage de pression allant d'environ 0 bar à environ 3 000 bars.

*Fig. 1A*

*Fig. 1B*

**Fig. 1C**

**Fig. 1D**

Fig. 1E

Fig. 1F

Fig. 1G

Fig. 1H

*Fig. 2A*

*Fig. 2B*

*Fig. 3A*

**Fig. 3B**

39b — 37b — 30b

35b —

— 32b

— 33b

— 31b
— 31c

36b — 38b — 34b

**Fig. 3C**

39b — 32b

**Fig. 3D**

— 30d

38d —

— 32d

— 39d
— 37d

35d —

— 39d
— 33d

— 34d

36d

*Fig. 4*

*Fig. 5*

*Fig. 6*

*Fig. 7*

Fig. 8

S, Max. Principal

+2.000e+07
+1.833e+07
+1.667e+07
+1.500e+07
+1.333e+07
+1.167e+07
+1.000e+07
+8.333e+06
+6.667e+06
+5.000e+06
+3.333e+06
+1.667e+06
+0.000e+00

810

Fig. 9

Fig. 10A

Fig. 10B

*Fig. 10C*

1010c

S, Max. Principal

+2.000e+07
+1.833e+07
+1.667e+07
+1.500e+07
+1.333e+07
+1.167e+07
+1.000e+07
+8.333e+06
+6.667e+06
+5.000e+06
+3.333e+06
+1.667e+06
+0.000e+00

*Fig. 10D*

1010d

S, Max. Principal

+2.000e+07
+1.833e+07
+1.667e+07
+1.500e+07
+1.333e+07
+1.167e+07
+1.000e+07
+8.333e+06
+6.667e+06
+5.000e+06
+3.333e+06
+1.667e+06
+0.000e+00

Fig. 10E

1010e

S, Max. Principal
+2.000e+07
+1.833e+07
+1.667e+07
+1.500e+07
+1.333e+07
+1.167e+07
+1.000e+07
+8.333e+06
+6.667e+06
+5.000e+06
+3.333e+06
+1.667e+06
+0.000e+00

*Fig. 11A*

1100

1102

1108

1106

1104

H

F

*Fig. 11B*

1104

1110

1106

*Fig. 12*

1200

Including in a downhole tool a package having one or more electronics components disposed therein and including characteristic dimension(s) to improve the strength thereof.

1202

Deploying the downhole tool in a subterranean environment.

1204